# FASCICULE DE BREVET EUROPEEN

(11) **EP 0 516 571 B1**
(45) Date de publication et mention de la délivrance du brevet: **02.01.1997**
(21) Numéro de dépôt: 92440063.3
(22) Date de dépôt: 29.05.1992
(51) Int. Cl.: H03B 9/14

(54) **Générateur hyperfréquence à élément source logé dans la cavité résonante**
Mikrowellengenerator mit in dem Hohlraumresonator montierten Quellen-Element
Microwave generator with source element located in the resonant cavity

(30) Priorité: 29.05.1991 FR 9106630
(43) Date de publication de la demande: 02.12.1992
(73) Titulaire: SADIS BRUKER SPECTROSPIN, SOCIETE ANONYME DE DIFFUSION DE L'INSTRUMENTATION SCIENTIFIQUE BRUKER SPECTROSPIN, F-67160 Wissembourg (FR)
(72) Inventeur: Ringeisen, Victor, F-67160 Riedseltz (FR); Martinache, Laurent, F-67500 Haguenau (FR)
(74) Mandataire: Nuss, Pierre

(56) Documents cités:
- EP-A- 0 284 485
- FR-A- 2 259 451
- JP-A-56 091 506
- US-A- 2 698 923
- US-A- 3 534 293
- PATENT ABSTRACTS OF JAPAN vol. 5, no. 163 (E-78)(835) 20 Octobre 1981

## Description

La présente invention se rapporte à un générateur hyperfréquence utilisant une source hyperfréquence directement installée dans la cavité résonante.

On connaît de nombreux générateurs hyperfréquence utilisant comme élément source un composant semi-conducteur.

Il s'agit des diodes connues, par exemple, sous les dénominations IMPATT, LSA, les diodes tunnel, les diodes à effet GUNN et divers autres composants présentant une résistance négative.

La diode émettrice est installée à l'intérieur d'un volume fermé raccordé à une cavité résonante attenante par l'intermédiaire d'un coupleur spécifique ajustable.

Selon le brevet américain n° 3 534 293, inventeur HARKLESS, l'élément source hyperfréquence est monté dans son circuit d'alimentation en série avec une tige rectiligne rayonnante disposée coaxialement dans un volume cylindrique. Cette tige rayonnante constitue l'antenne de couplage présente dans une chambre attenante à une cavité résonante cylindrique.

En raison de son rôle et de sa position, cette chambre constitue un prérésonateur.

Ce prérésonateur comporte une sortie transversale débouchant dans un conduit intermédiaire réglable et raccordé transversalement à une cavité résonante cylindrique à volume variable dont la sortie est reliée à la charge.

Ce prérésonateur présente des caractéristiques adaptées pour la gamme de fréquences envisagées. Il assure un filtrage des modes indésirables.

On accorde le coupleur par vis sur telle ou telle fréquence pour sélectionner les modes qui seront excités dans la cavité résonante.

Ce type de générateur à prérésonateur présente l'inconvénient d'une sélectivité importante en fréquence.

Ainsi, ces générateurs ne peuvent plus fournir au-delà d'un certain niveau, une puissance constante sur une large gamme de fréquences.

Or, certaines applications réclament le maintien d'une puissance suffisante s'étendant sur une large plage de fréquences tout en présentant un très bas bruit de phase.

La présente invention a pour but de remédier à ces inconvénients en proposant un générateur hyperfréquence de grande stabilité et de puissance significative sensiblement constante sur toute la bande de fréquences s'étendant de 9 à 10 GHz.

Le générateur hyperfréquence selon l'invention se montre remarquable en ce que la source hyperfréquence est située directement à l'intérieur de la cavité résonante du résonateur.

Préférentiellement, l'élément source fait partie intégrante de la cavité résonante et, peut, notamment, être disposée dans une entaille prévue dans l'épaisseur de l'une des parois de ladite cavité résonante, cette dernière étant couplée directement à la sortie du générateur.

Le générateur selon l'invention présente de nombreuses caractéristiques de performances et beaucoup d'avantages:
. couplage direct de l'élément source hyperfréquence au résonateur;
. puissance de sortie importante pour ce type de générateur (500 mW) lui permettant de remplacer dans certains cas un klystron reflex;
. très bas bruit de phase ce qui correspond à une excellente définition de fréquences;
. grande largeur de bande d'accord;
. bonne stabilité; peu de dérive en fréquence.

Il allie les principaux avantages constamment recherchés: puissance, bas bruit de phase, grande largeur de bande d'accord.

Les caractéristiques techniques et d'autres avantages de l'invention sont consignés dans la description qui suit, effectuée à titre d'exemple non limitatif sur des modes d'exécution en référence aux dessins annexés dans lesquels:
la figure 1 est une vue en perspective du corps de l'oscillateur hyperfréquence, cavité résonante ouverte, vue de côté;
la figure 2 est une vue en perspective de la cavité résonante fermée, vue de l'arrière, bloc mécanique représenté transparent;
la figure 3 est une vue en perspective de la plaque de fermeture fixe;
la figure 4 est une vue schématique en coupe longitudinale passant par la ligne des entailles de la cavité résonante;
la figure 5 est une vue en coupe longitudinale de la plaque de fermeture fixe selon une tranche passant au niveau de l'élément source;
la figure 6 est une vue schématique en coupe transversale suivant un plan médian de la plaque de fermeture mobile;
la figure 7 est une vue schématique en coupe suivant un plan passant par la ligne des entailles de la plaque de fermeture fixe;
la figure 8 est une vue de détail en plan montrant le relief de face avant de la plaque de fermeture fixe;
la figure 9 est une vue générale d'ensemble en perspective simplifiée du générateur, illustrative d'une variante présentant un élément source placé dans une entaille prévue dans la paroi latérale de la cavité résonante;
la figure 10 est une vue en coupe transversale suivant un plan perpendiculaire à l'axe du cylindre et passant par l'élément source.

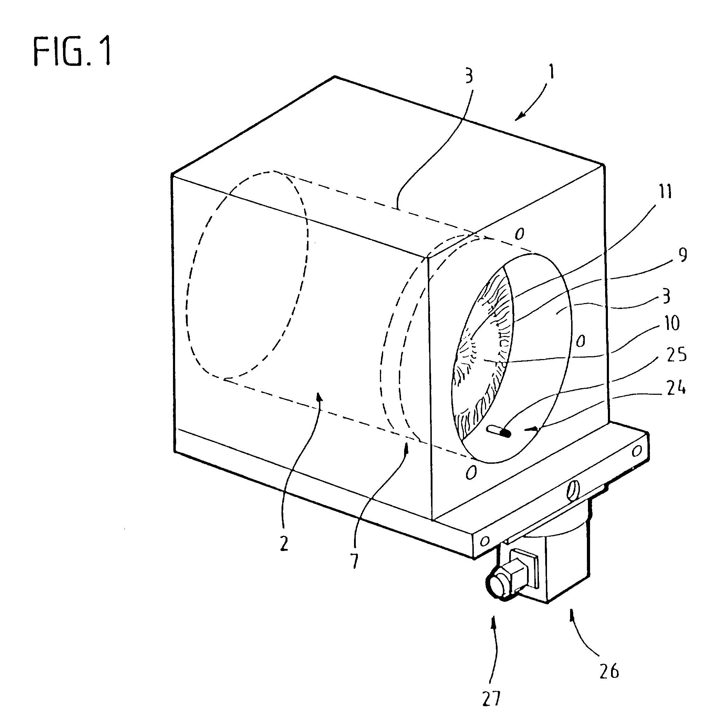

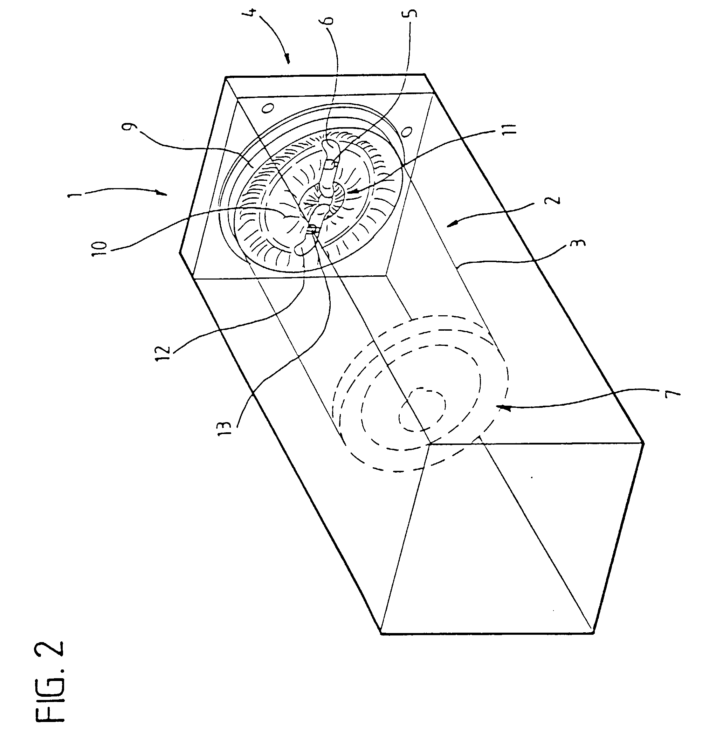

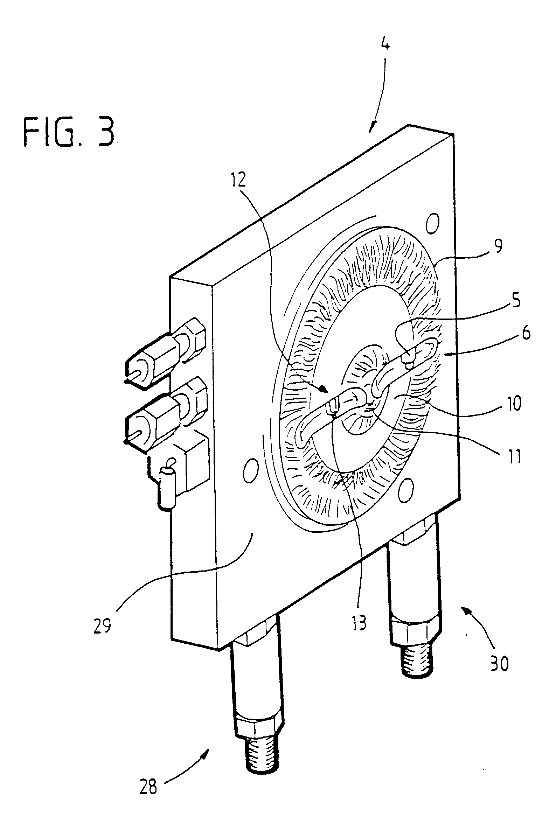

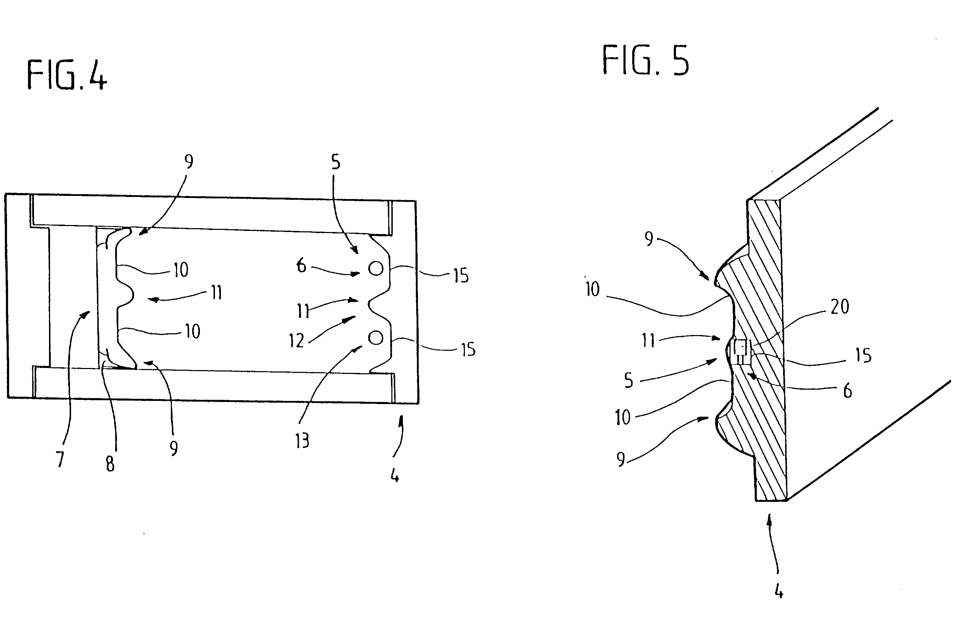

Conformément à l'invention, et comme le montrent les figure 1 à 10 des dessins annexés, le générateur hyperfréquence du type comprenant un élément source 5 de résistance négative attenant à une cavité résonante cylindrique 2 comprenant deux plaques transversales de fermeture 4, 7 pour la réalisation de l'accord sur une bande de fréquence, est principalement caractérisé en ce que l'élément source 5 est installé directement dans la cavité résonante 2.

Préférentiellement, l'élément source 5 fait partie intégrante de la cavité résonante 2, permettant de réaliser un couplage direct entre ledit élément source 5 et ladite cavité résonante 2.

Il peut, notamment, être disposé ou logé dans une entaille 6 prévue dans l'épaisseur de l'une des parois de la cavité résonante 2, cette dernière étant couplée directement à la sortie du générateur hyperfréquence.

Plus précisément, le générateur hyperfréquence, selon l'invention, se présente sous la forme d'un bloc mécanique 1 délimitant une enceinte à volume variable utilisée en cavité résonante 2 de forme générale cylindrique présentant une surface latérale enveloppante 3 obturée à l'une de ses extrémités par une plaque transversale de fermeture réfléchissante et fixe 4 contenant, selon une première variante, un élément source hyperfréquence 5 disposé dans une entaille 6 dite de source, pratiquée dans l'épaisseur de sa paroi. L'enceinte délimitée par le corps 1 est obturée à son autre extrémité par une plaque transversale de fermeture réfléchissante et mobile 7.

La deuxième plaque de fermeture 7 est mobile le long de la paroi latérale intérieure de l'enceinte cylindrique à la manière d'un piston.

La plaque de fermeture 7 est réalisée en métal et entourée d'une bague d'ajustement 8, en ferrite absorbante, à la section de la cavité résonante.

Cette plaque de fermeture mobile 7 permet d'accorder la cavité résonante sur une fréquence déterminée dans une plage de fréquences de 9 à 10 GHz.

Chaque plaque de fermeture présente un relief général en assiette comprenant une bordure annulaire incurvée 9, un fond plat 10 et une protubérance centrale 11 de forme générale conique.

La plaque de fermeture fixe 4 comporte en plus de l'entaille de source 6, une entaille dite d'accord 12. Ces entailles 6 et 12 sont radiales, dirigées suivant un même diamètre et disposées de part et d'autre de la protubérance centrale.

L'entaille 6 est appelée source car contenant l'élément source hyperfréquence 5 et l'entaille 12 est dite d'accord car contenant un élément capacitif 13 de caractéristiques variables permettant un accord rapide et fin en fréquence, après un réglage grossier au moyen de la plaque de fermeture 7.

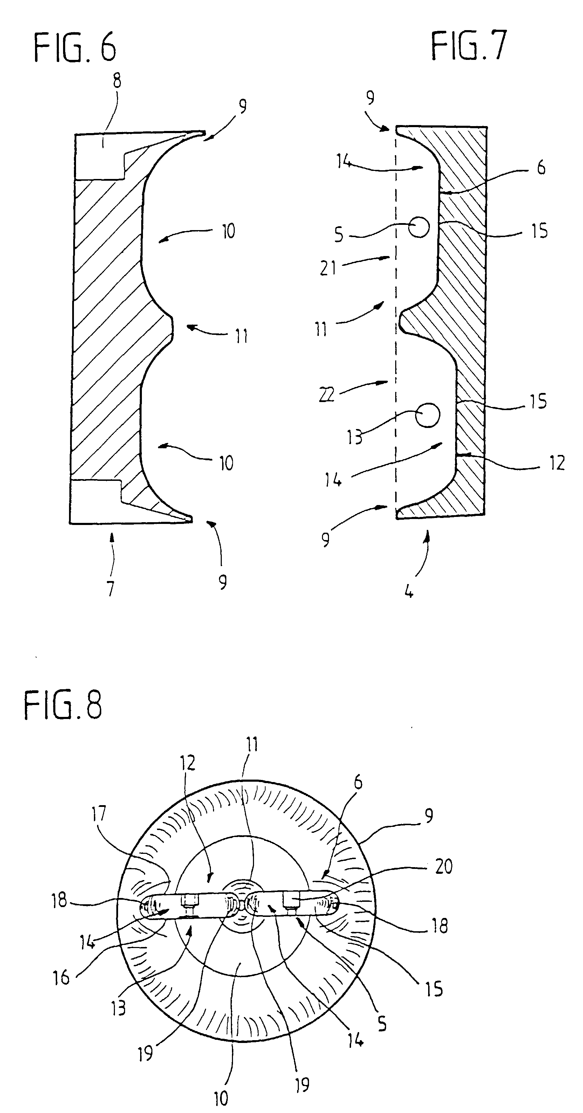

On décrira ci-après la conformation générale des entailles représentées plus particulièrement sur les vues en coupe des plaques de fermeture et sur la figure 8.

Chaque entaille présente, par exemple, sur pratiquement toute la longueur d'un rayon, la conformation générale d'une gorge 14 à fond plat 15 et à parois 16 et 17 parallèles et perpendiculaires au fond, formant une section de forme générale rectangulaire. La gorge se termine longitudinalement par deux extrémités identiques 18 et 19 sous la forme d'une rampe inclinée légèrement incurvée.

Comme indiqué ci-dessus, les deux entailles 6 et 12 se développent selon une direction générale radiale. Elles sont situées dans le prolongement l'une de l'autre sur un même diamètre.

Selon la variante représentée, les entailles 6 et 12 occupent chacune en longueur presque la totalité d'un rayon.

Dans l'entaille 6 de source est logé, en disposition transversale, et en retrait, l'élément source hyperfréquence 5, par exemple une diode à effet GUNN ou tout autre composant approprié pouvant présenter une résistance négative.

L'élément source hyperfréquence 5 présente un corps en contact physique direct et en contact électrique par une de ses bornes avec le corps de la cavité qui joue le rôle de masse physique et électrique et par l'autre de ses bornes au générateur continu de polarisation via une pièce de contact 20.

Le corps de l'élément source hyperfréquence 5 ainsi que celui de la capacité variable 13 sont disposés transversalement aux parois longitudinales parallèles de l'entaille en retrait par rapport aux plans d'entrée 21 et 22, respectivement des entailles 6 et 12 de source et d'accord comme représenté sur les figures.

Dans l'autre entaille 12 dite d'accord est logé l'élément capacitif 13 variable, par exemple une capacité connue sous le dénomination VARICAP dont la valeur est modifiable par sa tension de polarisation.

Cette capacité constitue le composant électronique d'un circuit d'accord à contrôle automatique de fréquence connu sous le sigle AFC. Il permet de modifier rapidement les caractéristiques d'accord de l'oscillateur hyperfréquence, mais seulement dans une bande étroite de fréquences. Cette capacité variable est utilisée ainsi à titre d'ajustement de la fréquence et à des fins de modulation rapide de fréquence.

L'accord à l'intérieur d'une bande plus large provient du déplacement de la plaque de fermeture mobile le long de la surface latérale 3 de la cavité résonante 2 à la manière d'un piston.

Les entailles de source 6 et d'accord 12 présentent des profondeurs différentes. L'entaille de source 6 est, par exemple, moins profonde que l'entaille d'accord 12 comme le montrent les figures.

D'autres emplacements sont possibles pour l'entaille dans laquelle se trouve placée la source hyperfréquence 5 comme indiqué ci-après.

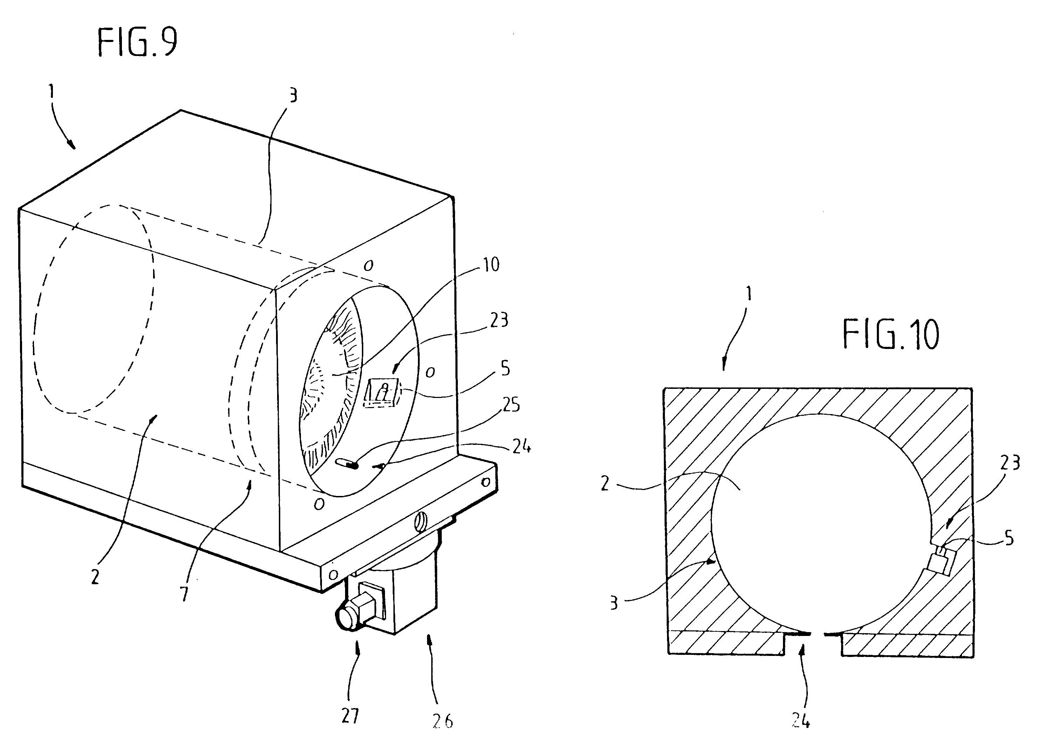

On obtient ainsi les mêmes performances de l'oscillateur en logeant l'élément source 5 dans une entaille longitudinale 23 évidée dans la paroi interne de la surface latérale du corps cylindrique de la cavité comme représenté schématiquement sur les figures 9 et 10.

Selon cette variante, l'entaille longitudinale 23 présente une forme générale identique ou analogue à celle existant dans la paroi de la plaque de fermeture fixe 4 de la première variante décrite ci-dessus. Elle se trouve orientée selon une direction générale parallèle à l'axe géométrique directeur du cylindre constituant le volume intérieur de la cavité résonante 2.

L'entaille longitudinale 23 contient l'élément source hyperfréquence 5 et, soit comme précédemment, dans une entaille adjacente la capacité variable connue sous la dénomination VARICAP, soit dans une entaille différente prévue à un autre emplacement.

On décrira maintenant la sortie du générateur. Le couplage de sortie s'effectue par un trou d'iris 24 accordable par une vis 25. Il débouche dans une pièce de raccordement 26 liée à un conduit de propagation hyperfréquence ou à un câble coaxial hyperfréquence 27 vers le circuit de charge ou d'utilisation.

On obtient les mêmes résultats en utilisant une antenne de couplage magnétique en sortie.

Les déplacements de la plaque de fermeture mobile 7 sont commandés par un micro-moteur à réducteur mécanique en prise sur un mécanisme de déplacement linéaire du piston avec asservissement à la valeur de fréquence affichée.

En raison du niveau de puissance émis et pour garder la source dans des conditions optimales de fonctionnement, un circuit de refroidissement est prévu à l'intérieur de la plaque de fermeture fixe 4. Il s'agit d'un refroidissement à circulation d'eau présentant un conduit d'entrée 28, une chambre intérieure de refroidissement 29 et un conduit de sortie 30.

Le réglage du générateur sur une fréquence donnée s'effectue de la façon suivante.

On règle la cavité résonante 2 le mieux possible pour présenter l'accord à la fréquence souhaitée à l'aide du déplacement de la plaque de fermeture mobile 7.

On ajuste ensuite précisément la fréquence à l'aide du circuit de contrôle automatique de fréquence de la capacité variable du type VARICAP.

Les domaines d'application visés par l'invention sont les suivants:
. spectroscopie dite RPE (Résonance Paramagnétique Electronique);
. applications scientifiques de mesures électroniques.

Il faut mentionner par ailleurs que les caractéristiques techniques décrites ci-dessus permettent d'envisager la construction de générateurs de fréquence notablement plus élevée, ou plus basse, située, par exemple, dans la gamme des 30-40 GHz avec un réglage possible de la fréquence sur une bande de plusieurs centaines de MHz de part et d'autre de la fréquence nominale.

Grâce à l'invention, il est donc possible de réaliser un générateur hyperfréquence présentant un couplage direct entre les éléments source 5 et de modulation 13 et la cavité résonante 2, par l'intermédiaire des entailles 6 et 12, dont les dimensions et la configuration géométriques influent sur les caractéristiques et le taux de ce couplage.

Le couplage décrit précédemment permet de bénéficier des avantages d'une conception massive alliée à un contact physique intime entre l'élément source 5 et la cavité résonante 2, indispensables dans le cas d'une source de puissance, sans dégrader le coefficient de qualité du résonateur ou chambre résonante 2.

Cette structure spécifique conforme à l'invention permet d'obtenir simultanément, d'une part, une puissance de sortie élevée, d'autre part, un bas bruit de phase, et enfin, une excellente stabilité de fréquence à court et à long terme, ce dernier avantage étant inhérent à l'inertie mécanique de la structure.

Bien entendu, l'invention n'est pas limitée aux modes de réalisation décrits et représentés aux dessins annexés. Des modifications restent possibles, notamment du point de vue de la constitution des divers éléments, ou par substitution d'équivalents techniques, sans sortir pour autant du domaine de protection de l'invention.

## Revendications

1. Générateur hyperfréquence du type comprenant un élément source (5) de résistance négative attenant à une cavité résonante cylindrique (2) comprenant deux plaques transversales de fermeture (4, 7) pour la réalisation de l'accord sur une bande de fréquence, caractérisé en ce que l'élément source (5) est installé directement dans la cavité résonante (2) et fait partie intégrante de ladite cavité, avec réalisation d'un couplage direct physique et électrique entre ledit élément source (5) et ladite cavité résonante (2).

2. Générateur selon la revendication 1, caractérisé en ce que l'élément source (5) est logé dans une des parois de la cavité résonante (2), cette dernière étant couplée directement à la sortie dudit générateur.

3. Générateur selon l'une quelconque des revendications 1 et 2, caractérisé en ce que la cavité résonante (2) est une enceinte cylindrique à volume variable obturée à l'une de ses extrémités par une plaque de fermeture fixe (4) et à son autre extrémité par une plaque de fermeture mobile (7).

4. Générateur selon l'une quelconque des revendications précédentes, caractérisé en ce que la source hyperfréquence (5) est logée dans une des parois latérales de fermeture de la cavité résonante (2).

5. Générateur selon la revendication 4, caractérisé en ce que la source hyperfréquence (5) est logée dans une entaille de source (6) dans la paroi fixe (4) de fermeture de la cavité résonante (2).

6. Générateur selon l'une quelconque des revendications 1 et 2, caractérisé en ce que la source hyperfréquence (5) est logée dans une entaille longitudinale (23) pratiquée dans la surface latérale (3) de la cavité résonante (2).

7. Générateur selon la revendication 6, caractérisé en ce que l'entaille (23) est orientée selon la direction de l'axe géométrique directeur du volume cylindrique de la cavité résonante (2).

8. Générateur selon la revendication 5, caractérisé en ce que l'entaille (6) de source est orientée selon un rayon.

9. Générateur selon la revendication 8, caractérisé en ce que l'entaille (6) de source se développe sur pratiquement la totalité d'un rayon.

10. Générateur selon l'une quelconque des revendications précédentes, caractérisé en ce qu'une entaille (12) de modulation et d'accord, adjacente à l'entaille (6) contenant l'élément source hyperfréquence, contient un élément capacitif (13).

11. Générateur selon la revendication 10, caractérisé en ce que l'élément capacitif (13) est une capacité variable.

12. Générateur selon la revendication 11, caractérisé en ce que la capacité variable (13) est du type connu sous la dénomination VARICAP.

13. Générateur selon l'une quelconque des revendications 1 à 12, caractérisé en ce que les plaques de fermeture fixe (4) et mobile (7) affectent une conformation générale en assiette délimitée par une bordure annulaire incurvée (9) et une protubérance centrale (11) de forme conique.

14. Générateur selon l'une quelconque des revendications 5 à 12, caractérisé en ce que l'entaille (6) de source est moins profonde que l'entaille (12) d'accord.

15. Générateur selon l'une quelconque des revendications 1 à 14, caractérisé en ce que la plaque de fermeture fixe (4) comprend deux entailles (6) et (12) radiales de part et d'autre de la protubérance centrale (11).

16. Générateur selon la revendication 15, caractérisé en ce que les entailles (6) et (12) sont disposées en prolongement l'une de l'autre sur un même diamètre.

17. Générateur selon l'une quelconque des revendications 5 à 16, caractérisé en ce que l'élément source hyperfréquence (5) est situé en position transversale médiane dans l'entaille (6).

18. Générateur selon l'une quelconque des revendications 10 à 17, caractérisé en ce que l'élément capacitif (13) est situé en position transversale médiane dans son entaille (12).

19. Générateur selon l'une quelconque des revendications 10 à 18, caractérisé en ce que les corps de l'élément source hyperfréquence (5) et celui de l'élément capacitif (13) sont situés en retrait par rapport au plan d'entrée respectif (21) et (22), de chacune des entailles (6) et (12).

## Patentansprüche

1. Mikrowellengenerator des Typs mit einem an einen zylindrischen Hohlraumresonator (2) mit zwei quer verlaufenden Schließplatten (4, 7) für die Realisierung der Abstimmung auf einem Frequenzband angrenzenden Quellenelement (5) negativen Widerstands, dadurch gekennzeichnet, daß das Quellenelement (5) direkt in dem Hohlraumresonator (2) installiert und einen wesentlichen Bestandteil des Hohlraums bildet, mit der Realisierung einer direkten physikalischen und elektrischen Kopplung zwischen dem Quellenelement (5) und dem Hohlraumresonator (2).

2. Generator nach Anspruch 1, dadurch gekennzeichnet, daß das Quellenelement (5) in einer der Wände des Hohlraumresonators (2) montiert ist, wobei letzterer direkt mit dem Ausgang des Generators gekoppelt ist.

3. Generator nach einem der Ansprüche 1 oder 2, dadurch gekennzeichnet, daß der Hohlraumresonator (2) eine zylindrische Umhüllung mit variablem Volumen ist, die an einem ihrer Enden durch eine fixe Schließplatte (4) und an ihrem anderen Ende durch eine bewegliche Schließplatte (7) verschlossen ist.

4. Generator nach einem der vorhergehenden Ansprüche, dadurch gekennzeichnet, daß die Mikrowellenquelle (5) in einer der seitlichen Schließwände des Hohlraumresonators (2) montiert ist.

5. Generator nach Anspruch 4, dadurch gekennzeichnet, daß die Mikrowellenquelle (5) in einer Ausnehmung der Quelle (6) in der fixen Schließwand (4) des Hohlraumresonators (2) montiert ist.

6. Generator nach einem der Ansprüche 1 oder 2, dadurch gekennzeichnet, daß die Mikrowellenquelle (5) in einer Längsausnehmung (23) montiert ist, die sich in der Seitenfläche (3) des Hohlraumresonators (2) befindet.

7. Generator nach Anspruch 6, dadurch gekennzeichnet, daß die Ausnehmung (23) nach der Richtung der geometrischen Hauptachse des zylindrischen Volumens des Hohlraumresonators (2) ausgerichtet ist.

8. Generator nach Anspruch 5, dadurch gekennzeichnet, daß die Ausnehmung (6) der Quelle radial ausgerichtet ist.

9. Generator nach Anspruch 8, dadurch gekennzeichnet, daß die Ausnehmung (6) der Quelle sich praktisch über die Gesamtheit eines Radius erstreckt.

10. Generator nach einem der vorhergehenden Ansprüche, dadurch gekennzeichnet, daß eine Ausnehmung (12) für die Modulation und die Abstimmung, die der das Mikrowellen-Quellenelement enthaltenden Ausnehmung (6) benachbart ist, ein kapazitives Element (13) enthält.

11. Generator nach Anspruch 10, dadurch gekennzeichnet, daß das kapazitive Element (13) eine variable Kapazität ist.

12. Generator nach Anspruch 11, dadurch gekennzeichnet, daß die variable Kapazität (13) von einem unter der Bezeichnung VARICAP bekannten Typ ist.

13. Generator nach einem der Ansprüche 1 bis 12, dadurch gekennzeichnet, daß die fixe und bewegliche Schließplatte (4, 7) eine allgemeine Formgebung nach Art eines Tellers aufweisen, die durch einen ringförmigen nach innen gekrümmten Rand (9) und einen zentralen Vorsprung (11) in konischer Form begrenzt wird.

14. Generator nach einem der Ansprüche 5 bis 12, dadurch gekennzeichnet, daß die Ausnehmung (6) für die Quelle weniger tief ist als die Ausnehmung (12) für die Abstimmung.

15. Generator nach einem der Ansprüche 1 bis 14, dadurch gekennzeichnet, daß die fixe Schließplatte (4) zwei radiale Ausnehmungen (6) und (12) beiderseits des zentralen Vorsprungs (11) aufweist.

16. Generator nach Anspruch 15, dadurch gekennzeichnet, daß die Ausnehmungen (6) und (12) in Verlängerung voneinander auf demselben Durchmesser vorgesehen sind.

17. Generator nach einem der Ansprüche 5 bis 16, dadurch gekennzeichnet, daß das Mikrowellen-Quellenelement (5) sich in transversaler mittlerer Position in der Ausnehmung (6) befindet.

18. Generator nach einem der Ansprüche 10 bis 17, dadurch gekennzeichnet, daß das kapazive Element (13) sich in transversaler mittlerer Position in seiner Ausnehmung (12) befindet.

19. Generator nach einem der Ansprüche 10 bis 18, dadurch gekennzeichnet, daß sich der Körper des Mikrowellen-Quellenelements (5) und der des kapazitiven Elements (13) nach hinten versetzt im Verhältnis zur Ebene des jeweiligen Eingangs (21) und (22) jeder der Ausnehmungen (6) und (12) befindet.

## Claims

1. A hyperfrequency generator of the type comprising a source element (5) of negative resistance adjoining a cylindrical resonant cavity (2) comprising two transverse closure plates (4, 7) for achieving tuning to a frequency band characterised in that the source element (5) is installed directly in the resonant cavity (2) and is an integral part of said cavity with the provision of direct physical and electrical coupling between said source element (5) and said resonant cavity (2).

2. A generator according to claim 1 characterised in that the source element (5) is accommodated in one of the walls of the resonant cavity (2), the latter being coupled directly to the output of said generator.

3. A generator according to either one of claims 1 and 2 characterised in that the resonant cavity (2) is a cylindrical enclosure of variable volume, which is closed at one of its ends by a fixed closure plate (4) and at its other end by a movable closure plate (7).

4. A generator according to any one of the preceding claims characterised in that the hyperfrequency source (5) is accommodated in one of the side closure walls of the resonant cavity (2).

5. A generator according to claim 4 characterised in that the hyperfrequency source (5) is accommodated in a source recess (6) in the fixed closure wall (4) of the resonant cavity (2).

6. A generator according to either one of claims 1 and 2 characterised in that the hyperfrequency source (5) is accommodated in a longitudinal recess (23) in the side surface (3) of the resonant cavity (2).

7. A generator according to claim 6 characterised in that the recess (23) is oriented in the direction of the director geometrical axis of the cylindrical volume of the resonant cavity (2).

8. A generator according to claim 5 characterised in that the source recess (6) is oriented along a radius.

9. A generator according to claim 8 characterised in that the source recess (6) is developed over practically the whole of a radius.

10. A generator according to any one of the preceding claims characterised in that a modulation and tuning recess (12) adjacent to the recess (6) containing the hyperfrequency source element contains a capacitive element (13).

11. A generator according to claim 10 characterised in that the capacitive element (13) is a variable capacitor.

12. A generator according to claim 11 characterised in that the variable capacitor (13) is of the type known under the name VARICAP.

13. A generator according to any one of claims 1 to 12 characterised in that the fixed and movable closure plates (4, 7) are of a general plate-shaped configuration defined by a curved annular rim (9) and a central protuberance (11) of conical shape.

14. A generator according to any one of claims 5 to 12 characterised in that the source recess (6) is of smaller depth than the tuning recess (12).

15. A generator according to any one of claims 1 to 14 characterised in that the fixed closure plate (4) comprises two radial recesses (6) and (12) on respective sides of the central protuberance (11).

16. A generator according to claim 15 characterised in that the recesses (6) and (12) are disposed in line with each other along the same diameter.

17. A generator according to any one of claims 5 to 16 characterised in that the hyperfrequency source element (5) is disposed in a central transverse position in the recess (6).

18. A generator according to any one of claims 10 to 17 characterised in that the capacitive element (13) is disposed in a transverse central position in its recess (12).

19. A generator according to any one of claims 10 to 18 characterised in that the bodies of the hyperfrequency source element (5) and that of the capacitive element (13) are disposed in set-back positions with respect to the respective entrance plane (21) and (22) of each of the recesses (6) and (12).
